# EUROPEAN PATENT APPLICATION

(11) **EP 4 439 177 A1**
(43) Date of publication of application: **02.10.2024**
(21) Application number: 23165825.3
(22) Date of filing: 31.03.2023
(51) Int. Cl.: G03F 7/00, H01L 21/673

(54) **SUBSTRATE STORAGE MODULE AND METHOD**

(71) Applicant: ASML Netherlands B.V., 5500 AH Veldhoven (NL)
(72) Inventor: NAIKWAD, Sanidhya, Sanjay, 5500 AH Veldhoven (NL); VAN GOMPEL, Petrus, Albertus, Johannes, Francisca, 5500 AH Veldhoven (NL); VAN BEUZEKOM, Aart, Adrianus, 5500 AH Veldhoven (NL); VAN BAREN, Martijn, 5500 AH Veldhoven (NL)
(74) Representative: ASML Netherlands B.V.

(57) **Abstract**

A substrate storage module for use as an integral part of a lithographic apparatus comprising a controllable environment for protecting a plurality of substrates from ambient air. The substrate storage module comprises a plurality of substrate supports for receiving the substrates, and a vacuum system fluidly coupled to the plurality of substrate supports. The vacuum system is configured to individually clamp and release the substrates.

## Description

### FIELD

The present invention relates to a substrate storage module and method of storing substrates, particular in the context of lithographic apparatus and methods.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

The maximum area of the patterning device that may be imaged onto the substrate using the lithographic apparatus (i.e. the maximum image area) may vary between different lithographic apparatus. For example, some lithographic apparatus may only be capable of imaging an area of the patterning device that is less than or equal to half of the maximum image area of other lithographic apparatus. A technique known as stitching may be used to overcome the limited maximum image area of some lithographic apparatus. Stitching includes performing at least two sub-exposures on neighboring areas of a substrate to form a combined image on the substrate. After a lithographic exposure is performed the substrate undergoes resist processing which includes, for example, a baking process. In the case of a stitched exposure, the baking process is postponed until each set of sub-exposures have taken place across all target areas of the substrate. A plurality of substrates that are to be lithographically processed as a group may be referred to as a lot. Delays may arise between performing the first set of sub-exposures of the first substrate of a lot and performing a subsequent set of sub-exposures of the final substrate of the lot. Lithographically exposed resist on the substrate may be vulnerable to degradation during such delays.

It is desirable to provide, for example, a substrate storage module and method that obviates or mitigates one or more problems of the prior art, whether identified herein or elsewhere.

### SUMMARY

According to a first aspect of the present disclosure, there is provided a substrate storage module for use as an integral part of a lithographic apparatus. The substrate storage module comprises a controllable environment for protecting a plurality of substrates from ambient air. The substrate storage module comprises a plurality of substrate supports for receiving the substrates. The substrate storage module comprises a vacuum system fluidly coupled to the plurality of substrate supports configured to individually clamp and release the substrates.

The substrate storage module advantageously provides a space in which substrates may be stored and protected from negative effects caused by ambient air after a lithographic exposure. For example, the substrate storage module may protect substrates that have undergone a sub-exposure during a stitched lithographic exposure for an extended period of time. The substrate storage module advantageously stores a plurality (e.g. at least eighteen) substrates making the substrate storage module suitable for storing substrates during a lithographic process (e.g. involving eighteen or more substrates).

Known substrate storage modules rely upon gravity to hold the substrates in place against the substrate supports. When known a substrate storage module is moved (e.g. to allow a robotic arm to access the stored substrates) and/or when mechanical vibrations are incident upon the known substrate storage module (e.g. due to movement of other components of a lithographic apparatus), the stored substrates undergo unwanted movements (e.g. shaking and/or slipping) from their original positions on the substrate supports. The unwanted movements may damage the substrates and/or introduce substrate defects due to frictional forces between the substrates and the substrate supports. The unwanted movements may risk damage to the substrates because the substrates are no longer flush with the substrate supports and/or may be misaligned with other components (e.g. the robotic arm) which may result in the substrates being knocked or dropped. The vacuum system of the present disclosure advantageously reduces the risk of the stored substrate undergoing unwanted movements by clamping and securing the substrates to the substrate supports using vacuum (i.e. gas pressure) forces. The vacuum system advantageously allows individual clamping and releasing of each stored substrate, thereby allowing one substrate to be removed or stored whilst the other substrates are prevented from slipping. This is particularly advantageous in the context of performing stitched lithographic exposures in which different substrates may be individually clamped or released at different times between sub-exposures. The vacuum system of the present disclosure advantageously allows the substrate supports to be moved at greater accelerations and speeds with reduced risk of stored substrates moving or falling from the substrate supports. This is in turn allows a greater throughput of substrates (e.g. a greater throughput of substrates through a lithographic exposure process).

The term "integral part" is intended to indicate that the substrate storage module remains connected to the lithographic apparatus throughout operation of the lithographic apparatus (i.e. the substrate storage module cannot be removed from the lithographic apparatus unless the lithographic apparatus is switched off).

A substrate storage module may be configured to be an integral part of a lithographic apparatus.

The controllable environment may be configured to protect at least eighteen substrates from ambient air.

The plurality of substrate supports may be configured to receive the substrates.

The plurality of substrate supports may comprise a coating configured to reduce friction between the plurality of substrate supports and the substrates.

The coating advantageously reduces frictional forces acting between the substrates and the substrate supports. This in turn advantageously reduces the risk of damage to the substrates and/or the introduction of substrate defects compared to known substrate storage modules.

Each substrate support may comprise the coating.

The coating may comprise diamond-like carbon.

Diamond-like carbon has been found to be particularly effective in reducing frictional forces between the substrate supports and the substrates.

The plurality of substrate supports may be configured to be individually removable from the substrate storage module.

Having individually removable substrate supports advantageously allows each substrate support to be taken away for maintenance or disposal without effecting the other substrate supports. For example, a substrate support may be defective, in which case the user may remove the defective substrate support from the substrate storage module and replace the defective substrate support with a spare functional substrate support. As another example, a substrate support may require maintenance, in which case the user may remove the substrate support from the substrate storage module for cleaning and/or fixing before reinserting the substrate support. The plurality of substrate supports may be configured to be individually replaceable, e.g. in a manner similar to cassettes.

The vacuum system may comprise a sensing system configured to detect the presence of the substrates in the plurality of substrate supports.

The sensing system may comprise one or more pressure sensors in one or more vacuum lines of the vacuum system.

The sensing system advantageously indicates the number of substrates held by the substrate supports as well as indicating which substrate supports are free to receive a substrate.

The substrate storage module may comprise a gas delivery system configured to provide a flow of gas across each substrate support within the substrate storage module.

The flow of gas over each substrate held by the substrate storage module advantageously reduces the risk of defectivity cross-contamination between stored substrates.

The gas may comprise filtered air.

The filtered air may comprise cleanroom air. The filtered air may comprise air having a particulate cleanliness greater than that provided by ISO 14644 class 1. The filtered air may comprise less than one particle per cubic meter having a size of about 0.1 µm or more.

The filtered air advantageously reduces the risk of contaminants being incident on the stored substrates.

The gas may comprise low humidity.

The gas may have a humidity of about 50% or less. The gas may have a humidity of about 30% or less. The gas may have a humidity of about 10% or less. The gas may have a humidity of about 7% or less. The gas may have a humidity of about 1% or less. The gas may have a humidity of about 0%.

Providing a flow of gas having a low humidity advantageously reduces the risk of degradation of the stored substrates.

The gas may comprise extreme clean dry air.

The extreme clean dry air may comprise <1 ppbv TOCv, where TOCv stands for Total Organic Compound, volatile, and ppbv stands for parts per billion, volume. The extreme clean dry air may comprise <1 ppbv TOCnv, where TOCnv stand for Total Organic Compound, non-volatile. The extreme clean dry air may comprise <100 ppbv HzO. The extreme clean dry air may have a particulate cleanliness equal to or greater than ISO 14644 class 2.

Extreme clean dry air has been found to be particularly effective in protecting the stored substrates (e.g. the photoresist of lithographic substrates) from degradation, thereby improving a lifetime of the substrates.

The gas delivery system may comprise a filter.

The number of substrate supports may be less than twenty-five.

A substrate lot typically comprises twenty-five substrates. In the example of a lithographic apparatus, at least one substrate may always be present in a wafer handler of the lithographic apparatus. As such, not all twenty-five substrates will be in the substrate storage module at the same time. Given this, the number of substrate supports in the substrate storage module may be less than the number of substrates in a lot (i.e. less than twenty-five). This advantageously reduces the volume of the substrate storage module. Reducing the volume of the substrate storage module may reduce the amount of time needed to move from the first substrate support to the final substrate support, which may in turn increase a throughput of a lithographic apparatus. Reducing the volume of the substrate storage module may provide space for new components, such as the vacuum system and/or sensing system.

The substrate storage module may comprise a grounded conductor configured to reduce a risk of electrostatic discharge between the substrates.

Electrostatic charges may build in the substrate storage module, e.g. on the substrate supports and/or the stored substrates. The grounded conductor advantageously provides a safe outlet for electrostatic discharges, thereby reducing the risk of electrical damage to the stored substrate and/or the substrate supports.

According to an embodiment of the present disclosure, there is provided a lithographic apparatus arranged to project a pattern from a patterning device onto a substrate, comprising the substrate storage module of the first aspect.

The lithographic apparatus may comprise a vacuum substrate handling module, an atmospheric substrate handling module, and a transition substrate handling module disposed between the vacuum substrate handling module and the atmospheric substrate handling module. The substrate storage module may be located in the atmospheric substrate handling module.

According to a second aspect of the present disclosure, there is provided a method of storing a plurality of substrates in a controllable environment for protecting the substrates from ambient air. The method comprises using a vacuum system to individually clamp and release the substrates from a plurality of substrate supports.

The method may comprise using the vacuum system to detect the presence of the substrates in the plurality of substrate supports.

The method may comprise providing a flow of gas across each substrate.

The gas may comprise filtered air.

The gas may comprise low humidity.

The gas may comprise extreme clean dry air.

The method may comprise providing a grounded conductor to reduce a risk of electrostatic discharge between the substrates.

The method may comprise storing the substrates in a non-linear sequence.

Known substrate storage methods involve storing the substrates in a linear sequence. For example, known substrate storage methods involve storing substrates in a first substrate support, followed by a second substrate support adjacent the first substrate support, followed by a third substrate support adjacent the second substrate support, etc. That is, a known method of storing six substrates involves storing the substrate in the following linear sequence of substrate supports: 1, 2, 3, 4, 5, 6. In this case, the distance between the first substrate (i.e. stored in substrate support 1) and the final substrate (i.e. in substrate support 6) is relatively large. By storing the substrates in a non-linear sequence (e.g. the following non-linear sequence of substrate supports: 1, 3, 5, 6, 4, 2), then the distance between the first substrate (i.e. stored in substrate support 1) and the final substrate (i.e. stored in substrate support 2) is reduced compared to the known method. This advantageously reduces the variety of distances needed to store or remove each substrate compared to the extremes of the known method. This may in turn reduce unwanted movement of the substrates.

According to an embodiment of the present disclosure, there is provided a method of lithographically exposing a plurality of substrates to form a stitched pattern on the substrates. The method comprises performing a first set of sub-exposures on a substrate to form a partially exposed substrate. The method comprises storing the partially exposed substrate in accordance with the second aspect of the present disclosure. The method comprises repeating the first and second steps for other substrates in the plurality of substrates. The method comprises removing the partially exposed substrates from storage and performing a second set of sub-exposures on the partially exposed substrates to form substrates having stitched patterns.

According to an embodiment of the present disclosure, there is provided a device manufactured according to the method of lithographically exposing a plurality of substrates to form a stitched pattern on the substrates.

### BRIEF DESCRIPTION OF THE DRAWINGS

Embodiments of the invention will now be described, by way of example only, with reference to the accompanying schematic drawings, in which:
- Fig. 1 schematically depicts a lithographic system comprising a lithographic apparatus, a radiation source and a substrate storage module according to the present disclosure.
- Fig. 2 schematically depicts a maximum image area of a first lithographic apparatus compared with two maximum image areas of a second lithographic apparatus.
- Fig. 3 schematically depicts a view from above a portion of a lithographic apparatus having a substrate storage module according to the present disclosure.
- Fig. 4 schematically depicts a view from the front of a substrate storage module according to the present disclosure.
- Fig. 5 schematically depicts a substrate storage module in accordance with the present disclosure.
- Fig. 6 schematically depicts a magnified view of three vacuum clamps of the substrate supports of Fig. 5.
- Fig. 7 schematically depicts a substrate storage module comprising an alternative arrangement of a vacuum system for individually clamping and releasing substrates in accordance with the present disclosure.
- Fig. 8 shows a flow chart of a method of exposing a plurality of substrates to form a stitched pattern on the substrates according to the present disclosure.

### DETAILED DESCRIPTION

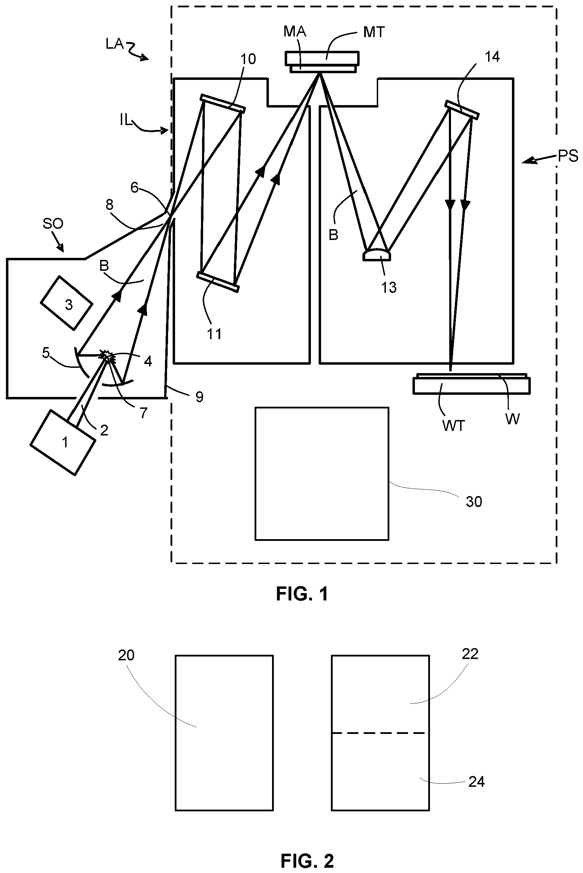

Fig. 1 schematically depicts a lithographic system including a substrate storage module 30 according to the present disclosure. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask or reticle), a projection system PS and a substrate table WT configured to support a substrate W. The illumination system IL is configured to condition the radiation beam B before it is incident upon the patterning device MA. The projection system PS is configured to project the radiation beam B (now patterned by the mask MA) onto the substrate W. The substrate W may include previously formed patterns. Where this is the case, the lithographic apparatus may align the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Fig. 1 is of a type which may be referred to as a laser produced plasma (LPP) source). A laser 1, which may for example be a CO₂ laser, is arranged to deposit energy via a laser beam 2 into a fuel, such as tin (Sn) which is provided from a fuel emitter 3. Although tin is referred to in the following description, any suitable fuel may be used. The fuel may for example be in liquid form, and may for example be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a plasma 7 at the plasma formation region 4. Radiation, including EUV radiation, is emitted from the plasma 7 during de-excitation and recombination of ions of the plasma.

The EUV radiation is collected and focused by a near normal incidence radiation collector 5 (sometimes referred to more generally as a normal incidence radiation collector). The collector 5 may have a multilayer structure which is arranged to reflect EUV radiation (e.g. EUV radiation having a desired wavelength such as 13.5 nm). The collector 5 may have an elliptical configuration, having two ellipse focal points. A first focal point may be at the plasma formation region 4, and a second focal point may be at an intermediate focus 6, as discussed below.

The laser 1 may be separated from the radiation source SO. Where this is the case, the laser beam 2 may be passed from the laser 1 to the radiation source SO with the aid of a beam delivery system (not shown) comprising, for example, suitable directing mirrors and/or a beam expander, and/or other optics. The laser 1 and the radiation source SO may together be considered to be a radiation system.

Radiation that is reflected by the collector 5 forms a radiation beam B. The radiation beam B is focused at point 6 to form an image of the plasma formation region 4, which acts as a virtual radiation source for the illumination system IL. The point 6 at which the radiation beam B is focused may be referred to as the intermediate focus. The radiation source SO is arranged such that the intermediate focus 6 is located at or near to an opening 8 in an enclosing structure 9 of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system PS comprises a plurality of mirrors 13, 14 which are configured to project the radiation beam B onto a substrate W held by the substrate table WT. The projection system PS may apply a reduction factor to the radiation beam B, forming an image with features that are smaller than corresponding features on the patterning device MA. A reduction factor of four may, for example, be applied. Although the projection system PS has two mirrors 13, 14 in Fig. 1, the projection system PS may include any number of mirrors (e.g. six mirrors).

The radiation sources SO shown in Fig. 1 may include components which are not illustrated. For example, a spectral filter may be provided in the radiation source SO. The spectral filter may be substantially transmissive for EUV radiation but substantially blocking for other wavelengths of radiation such as infrared radiation.

As discussed above, some lithographic apparatus may be used to perform stitched lithographic exposures in which at least two sub-exposures take place on neighboring areas of the substrate W to image a desired area of the patterning device MA onto the substrate W. Fig. 2 schematically depicts a maximum image area 20 of a first lithographic apparatus compared with two maximum image areas 22, 24 of a second lithographic apparatus. In the example of Fig. 2, the maximum image area 22, 24 of the second lithographic apparatus is half of the maximum image area 20 of the first lithographic apparatus. Whereas the first lithographic apparatus required one exposure 20 to image the desired area onto the substrate, the second lithographic apparatus required two sub-exposures 22, 24 to image the same desired area onto the substrate. In the case of the second lithographic apparatus, a first sub-exposure 22 is performed using a first area of the patterning device then a second sub-exposure 24 is performed either using a different area of the patterning device or using a different patterning device. The second sub-exposure 24 takes place on a neighboring area of the substrate such that the image formed on the substrate is equivalent to the image 20 formed using the first lithographic apparatus. Other lithographic apparatus may have a smaller maximum image area than the second lithographic apparatus. For example, other lithographic apparatus may have a maximum image area that is a third of the maximum image area 20 of the first lithographic apparatus. In this case, three sub-exposures may be performed such that the image formed on the substrate is equivalent to the image 20 formed using the first lithographic apparatus.

After a lithographic exposure has been performed, the substrate may undergo resist processing which may, for example, include a baking process. In the case of a stitched exposure, the baking process is postponed until each sub-exposure has taken place across all target areas of the substrate. In some lithographic processes, the baking process may not begin until all substrates of a substrate lot (e.g. twenty-five substrates) have undergone the stitched exposure. If the baking process takes place for an entire lot of substrates, then long delays (e.g. between five and ten minutes) may arise between performing the first set of sub-exposures on the first substrate of the lot and performing the final set of sub-exposures on the final substrate of the lot. A delay between performing an exposure and baking the substrate may negatively affect the structures that are to be formed on the substrate due, at least in part, to interactions between the resist on the substrate and the ambient air in which the substrate is held. In general, the longer a lithographically exposed substrate is held in ambient air, the worse the quality of the structures formed on the substrate will be.

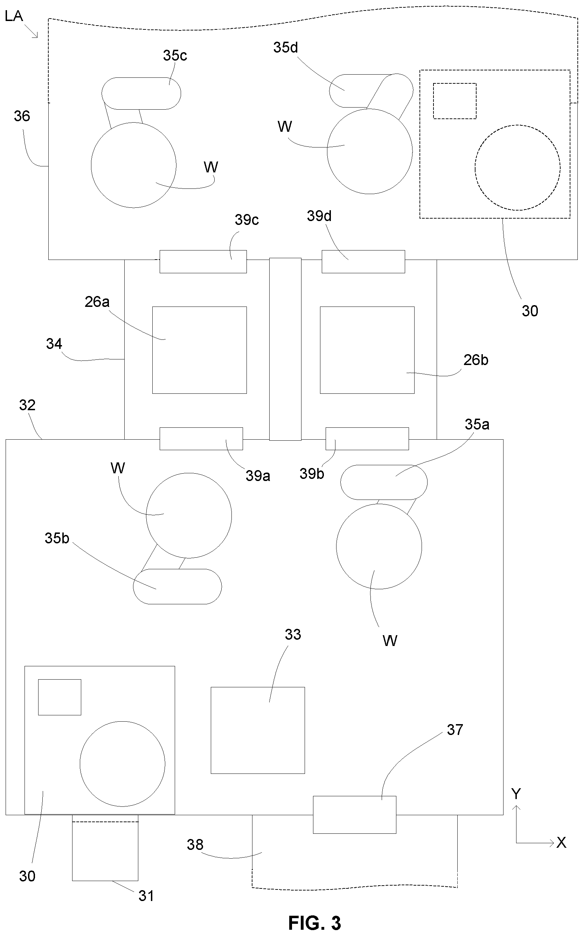

One method of reducing the negative effect associated with ambient air interacting with a lithographically exposed substrate before the substrate undergoes resist processing includes providing the lithographic apparatus with a substrate storage module for protecting lithographically exposed substrates from ambient air. Fig. 3 schematically depicts a view from above a portion of a lithographic apparatus LA having a substrate storage module 30 according to the present disclosure. The portion of the lithographic apparatus LA comprises an atmospheric substrate handling module 32, a transition substrate handling module 34 and a vacuum substrate handling module 36. The atmospheric module 32 is configured to receive substrates W from a track (not shown) via a track interface 37under cleanroom conditions (i.e. in ambient air having a controlled level of contaminants) and transfer the substrates W to the transition module 34. The transition module 34 is configured to receive a substrate W from the atmospheric module 32 under atmospheric conditions, generate a vacuum environment, and provide the substrate W to the vacuum module 36. The transition module 34 comprises doors 39a-d that are configured to form a seal when the transition module 34 converts its internal environment from atmospheric conditions to vacuum conditions and vice versa. The transition module 34 comprises stages 26a-b configured to hold substrates whilst the transition between atmospheric conditions and vacuum conditions takes place. The vacuum module 36 is configured to hold the substrate W under vacuum conditions whilst the substrate W is used in the lithographic apparatus LA (e.g. during measurement of the substrate and/or during lithographic exposure of the substrate).

The atmospheric module 32 may comprise a substrate measurement stage 33 that is configured to measure characteristics such as, for example, a position and/or a temperature of a substrate that is located on the substrate measurement stage 33. The substrate measurement stage 33 may be configured to perform additional functions such as, for example, to correct for position offsets of the substrate (e.g. in cylindrical polar coordinates) and/or to thermally condition the substrate to reach a desired temperature. The vacuum module 36 may also comprise a measurement stage (not shown). A measurement stage 33 present in the atmospheric module 32 may be referred to as an atmospheric prealigner. A measurement stage present in the vacuum module 36 may be referred to as a vacuum prealigner. The atmospheric module 32 may comprise a track interface 37. The track interface 37 may be configured to provide an entrance to and/or exit from a track 38. The track interface 37 and the track 38 may comprise ingoing sections (not shown) for substrates entering the lithographic apparatus and outgoing sections (not shown) for substrates leaving the lithographic apparatus. For example, the track 38 may provide outgoing substrates to a resist processing apparatus (not shown) which may, for example, be configured to receive lithographically exposed substrates W and perform a baking process on the substrates. Additionally or alternatively the resist processing apparatus may be configured to coat substrates W with a layer of resist and provide the substrates to the ingoing sections of the track 38 and track interface 37 for re-entering the lithographic apparatus LA for a lithographic exposure. The atmospheric module 32 may comprise one or more store units (not shown) configured to receive incoming substrates from the ingoing section of the track interface 37 and/or provide outgoing substrates to the outgoing section of the track interface 37. The atmospheric module 32 may comprise one or more robotic arms 35a-b. The robotic arms 35a-b may be configured to collect substrates from and/or provide substrates to the one or more store units. The robotic arms 35a-b may be configured to provide substrates W to and/or receive substrates from the substrate carrier 31, the substrate storage module 30, the transition module 34 and the track interface 37. In general, the substrate carrier 31 is used for storing and transporting substrates for calibrations and test procedures rather than lithographic production. The robotic arms 35a-b may be configured to move substrates W between different parts of the atmospheric module 32 (e.g. moving substrates W between the substrate measurement stage 33 and the track interface 37).

The substrate storage module 30 may be an integral part of the lithographic apparatus LA. That is, the substrate storage module 30 may remain connected to the lithographic apparatus LA throughout operation of the lithographic apparatus LA (i.e. the substrate storage module 30 cannot be removed from the lithographic apparatus LA unless the lithographic apparatus is switched off). This is because the substrate storage module 30 is amongst components of the lithographic apparatus (e.g. robotic arms 35a-d) and it may not be safe to attempt to access the substrate storage module 30 during operation of the lithographic apparatus LA. In the example of Fig. 3, the substrate storage module 30 is an integral part of the atmospheric module 32. The substrate storage module 30 may be an integral part of the transition module 34, the vacuum module 36 or any other part of the lithographic apparatus LA.

The substrate storage module 30 comprises a controllable environment for protecting a plurality of substrates from ambient air. The substrate storage module 30 may be configured to store at least eighteen substrates. The substrate storage module 30 may be configured to store at least twenty substrates. When the substrate storage module 30 is an integral part of the atmospheric module 32, the substrate storage module 30 may be provided with a gas delivery system configured to provide gas having a desired chemical composition and humidity. When the substrate storage module 30 is an integral part of the vacuum module 36, the substrate storage module 30 may be provided with a gas delivery system configured to provide gas having a desired chemical composition and humidity. When the substrate storage module 30 is an integral part of the vacuum module 36 and the substrate storage module 30 comprises a gas delivery system, then the substrate storage module 30 may also comprise a door (e.g. an airlock) configured to seal the internal environment of the substrate storage module such that gas does not escape into the vacuum module 36.

In contrast to the substrate storage module 30, the substrate carrier 31 is not an integral part of the lithographic apparatus LA because the substrate carrier 31 is temporarily connected to an external part of the lithographic apparatus LA and is configured to be easily attached and detached from the lithographic apparatus LA during operation of the lithographic apparatus LA. The substrate carrier 31 may, for example, comprise a front opening unified pod (FOUP). FOUPs are used to transport substrates between lithographic apparatus and resist processing apparatus. The internal environment of a FOUP 31 typically comprises ambient air. Ambient air is also present in the internal environment of the atmospheric module 32. Whilst the ambient air present in the substrate carrier 31 and the atmospheric module 32 may be filtered and/or otherwise "cleaned" to a cleanroom specification, the ambient air may still have a negative effect on substrates that have undergone a lithographic exposure but are yet to undergo a baking process. The negative effects caused to lithographically exposed substrates by the ambient air may be due to, for example, undesirable humidity levels and/or an undesirable chemical composition (e.g. an undesirable concentration of amines) of the ambient air. In contrast, the substrate storage module 30 comprises a controllable environment for protecting a plurality (e.g. at least eighteen) lithographically exposed substrates from ambient air. For example, the temperature, the humidity and/or the concentration of amines present in a gas provided to the substrate storage module 30 may be controlled.

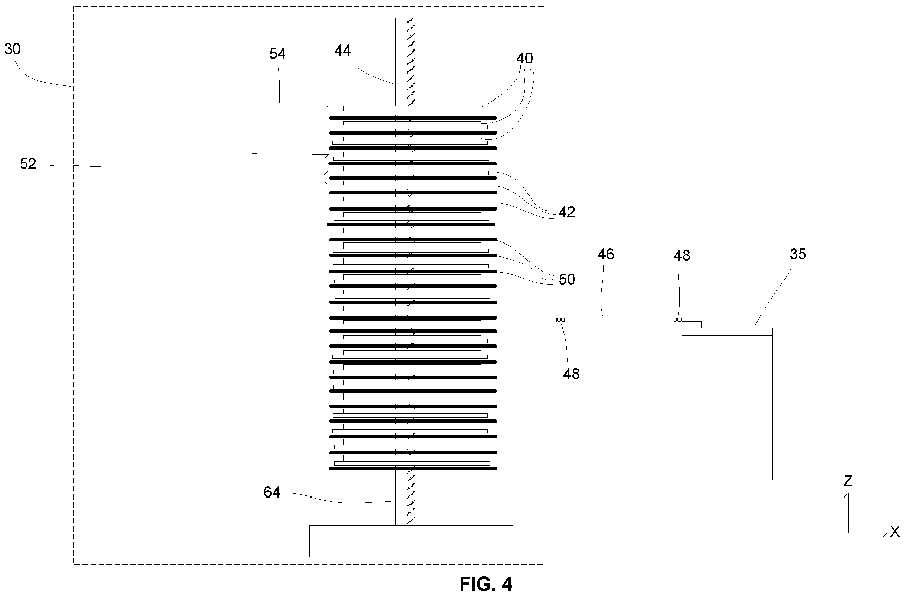

Fig. 4 schematically depicts a view from the front of a substrate storage module 30 according to the present disclosure. The substrate storage module 30 is configured to store a plurality (e.g. at least eighteen) substrates 40. The substrate storage module 30 may be configured to store less than an entire lot of substrates 40 (e.g. less than twenty-five substrates). For example, the substrate storage module 30 may be configured to hold twenty-four substrates 40 or less. This is because, whilst there are twenty-five substrates 40 in a lot, one or more substrates may be outside the substrate storage module 30 interacting with other parts of the lithographic apparatus LA, e.g. being moved by a robotic arm 35a-d or being measured on a measurement stage. In this case, the substrate storage module 30 may assist in the stitched exposure of the entire lot of substrates 40 whilst having capacity for less than the entire lot of substrates 40. In the example of Fig. 4, the substrate storage module 30 is configured to store twenty-four substrates 40.

The substrate storage module 30 may be formed from materials such as, for example, metals, polycarbonate and/or carbon-filled polyether ether ketone. The substrate storage module 30 may comprise a door and a mechanism (not shown) configured to actuate the door.

The substrate storage module 30 comprises a plurality of substrate supports 42 for receiving substrates 40. The substrate supports 42 are stacked in a single column 44. In the example of Fig. 4, the substrate storage module 30 is an integral part of the atmospheric module (not shown). The substrate supports 42 may be formed of a material having a low conductivity and may be electrically grounded to reduce a risk of unwanted electrical discharges occurring in the substrate storage module 30.

A robotic arm 35 of the atmospheric module is configured to receive an incoming substrate (e.g. from the vacuum module) and place the incoming substrate on an empty substrate support 42 in the substrate storage module 30. The robotic arm 35 is also configured to retrieve an outgoing substrate from a substrate support 42 of the substrate storage module 30 and remove the outgoing substrate from the substrate storage module 30. The substrate storage module 30 further comprises an actuator 64 configured to move the substrate supports 42. The actuator 64 may be configured to move all of the substrate supports 42 simultaneously. The actuator 64 may, for example, comprise a moveable rod 64 configured to move the substrate supports 42 along a support column 44 in the z direction, e.g. with respect to the robotic arm 35. The actuator 64 may move the substrate supports with an acceleration of, for example, about 0.2 ms⁻² or less. The actuator 64 may reduce or remove the extent of movement required of the robotic arm 35. The actuator 64 may, for example, have a range of movement along the z direction of between about 500 mm and about 1000 mm, e.g. about 850 mm. The robotic arm 35 may then be configured to move along the x direction and/or the y direction and retrieve a substrate 40 from the selected substrate support 42 by attaching the substrate 40 to a substrate platform 46 using an attachment mechanism 48. The robotic arm 35 may, for example, have a range of movement along the x direction and/or along the y direction of between about 300 mm and about 500 mm. The robotic arm 35 may then move the substrate 40 to, for example, the transition module 34 (see Figure 3) in preparation for a lithographic exposure in the vacuum module 36. It will be appreciated that the provision of, and reference to, Cartesian coordinates in the figures is merely to aid understanding of the figures, and that components of the lithographic system (e.g. the robotic arm 35) may operate using other coordinate systems, e.g. cylindrical coordinates.

The attachment mechanism 48 may, for example, comprise one or more suction cups or a mechanical or electrostatic clamp. Alternatively, the attachment mechanism 48 may comprise a material having a suitably high friction coefficient for attaching a substrate to the substrate platform 46 when in contact with the substrate, e.g. Viton ^{®}. In the example of Fig. 4, the attachment mechanism 48 comprises two suction cups proximate an edge of the substrate platform 46. The suction cups 48 are configured to act on a lower surface of the substrate 40. The form of the attachment mechanism 48 may depend upon an environment in which the robotic arm 35 is configured to operate. For example, if the robotic arm 35 is configured to operate under cleanroom conditions (e.g. in the atmospheric module) then the attachment mechanism 48 may comprise a mechanical clamp or a suction cup. Alternatively, if the robotic arm 35 is configured to operate under vacuum conditions (e.g. in the vacuum module) then the attachment mechanism 48 may comprise an electrostatic clamp.

The substrate storage module 30 comprises a shield 50 located between neighboring slots 42. The shield 50 may, for example, comprise a sheet of metal. In the example of Fig. 4, the substrate storage module 30 comprises a shield 50 between every neighboring substrate support 42. The shield 50 acts as a physical barrier which reduces the amount of debris transferring between stored substrates 40. For example, when the robotic arm 35 places a substrate 40 in a substrate support 42 and/or retrieves a substrate 40 from a substrate support 42, some debris may be generated. The shield 50 reduces the amount of debris that can reach other substrates 40 stored in the substrate storage module 30 (e.g. the shield prevents debris from falling onto lower stored substrates 40).

The substrate storage module 30 may comprise a gas delivery system 52. The gas delivery system 52 may operate in a similar manner to an air shower by providing a continuous flow of gas 54 within the substrate storage module 30. The gas delivery system 52 is configured to provide uniform flows of gas 54 across each substrate support 42 within the substrate storage module 30. That is, the direction of the flow of gas 54 is selected relative to the substrate supports 42 so as to provide uniform flows of gas 54 across an exposure surface of each substrate 40 stored in the substrate storage module 30. The gas delivered to the substrate storage module 30 via the gas delivery system 52 may have a desired chemical composition and/or humidity. The gas 54 may comprise filtered air. Filtered air may comprise air having a particulate cleanliness greater than that provided by ISO 14644 class 1. Filtered air may comprise less than one particle per cubic meter having a size of about 0.1 µm or more. The gas 54 may comprise low humidity. The gas 54 may have a humidity of about 50% or less. The gas 54 may have a humidity of about 30% or less. The gas 54 may have a humidity of about 10% or less. The gas 54 may have a humidity of about 7% or less. The gas 54 may have a humidity of about 1% or less. The gas 54 may have a humidity of about 0%. The gas 54 may comprise extreme clean dry air (XCDA). Extreme clean dry air may comprise <1 ppbv TOCv, where TOCv stands for Total Organic Compound, volatile, and ppbv stands for parts per billion, volume. Extreme clean dry air may comprise <1 ppbv TOCnv, where TOCnv stand for Total Organic Compound, non-volatile. Extreme clean dry air may comprise <100 ppbv HzO. Extreme clean dry air may have a particulate cleanliness equal to or greater than ISO 14644 class 2. To this end, the gas delivery system 52 may comprise a filter.

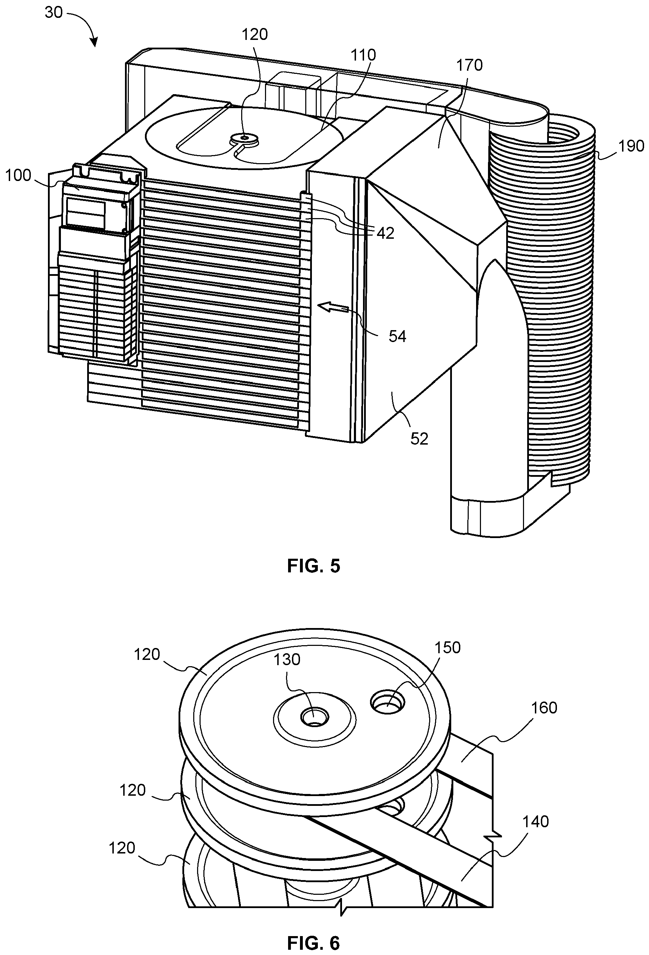

Fig. 5 schematically depicts a substrate storage module 30 in accordance with the present disclosure. The substrate storage module 30 is suitable for use as an integral part of a lithographic apparatus, such as the lithographic apparatus LA of Fig. 1. The substrate storage module 30 comprises a controllable environment for protecting a plurality (e.g. at least eighteen) substrates 110 from ambient air. In the example of Fig. 5, the substrate storage module 30 comprises twenty-five substrate supports 42. Each substrate support 42 is suitable for receiving one substrate 110. As such, the substrate storage module 30 of Fig. 5 is suitable for receiving twenty-five substrates 110. Each substrate support 42 comprises a vacuum clamp 120 configured to receive a substrate 110. The shape of the vacuum clamp 120 may correspond to the shape of the substrate 110 to be stored. In the example of Fig. 5, the substrate storage module 30 is configured to store circular substrates 110, so the vacuum clamps 120 are circular or ringed. Other shapes may be used.

The substrate storage module 30 comprises a gas delivery system 52 configured to provide flows of gas 54 (only one flow is shown in fig. 5) across exposure surfaces (i.e. upper surfaces) of the stored substrates 110. The gas delivery system 52 may comprise one outlet per substrate support 42 configured to direct a flow of gas across each substrate 110. In the example of Fig. 5, the gas delivery system 52 is provided with gas (e.g. air which may pass through a filter in the gas delivery system 52) via a telescopic pipe 190. The telescopic pipe 190 allows the substrate supports 42 to be moved up and down without interrupting the flow of gas to the gas delivery system 52. Electrical connections to the components of the substrate storage module 30 may be provided via dynamic cabling that allows the substrate supports 42 to move up and down without interrupting the provision of electrical signals and/or power to the components of the substrate storage module 30.

The substrate storage module 30 comprises a vacuum system 100 fluidly coupled to the substrate supports 42. The vacuum system 100 is configured to individually clamp and release the substrates 110 to/from the substrate supports 42. The vacuum system 100 may comprise a pneumatic vacuum mechanism. A vacuum clamp 120 is provided at the centre of the substrate support 42. The vacuum system 100 is fluidly coupled to the vacuum clamps 120 of the substrate supports 42.

Fig. 6 schematically depicts a magnified view of three vacuum clamps 120 of the substrate supports 42 of Fig. 5. Each vacuum clamp 120 comprises a first aperture 130 that is fluidly coupled to a first channel 140 and a second aperture 150 that is fluidly coupled to a second channel 160. Only the apertures 130, 150 and channels 140, 160 belonging to the uppermost vacuum clamp 120 are fully visible in Fig. 6. The first and second channels 140, 160 are fluidly coupled to the vacuum system 100 (visible in Fig. 5). The vacuum system 100 is configured to control a flow of gas within the channels 140, 160 and thereby control actuation of the vacuum clamp 120. When a substrate (not shown in Fig. 6) is to be clamped to a substrate support 42, the vacuum system 100 may draw gas from the apertures 130, 150 along the channels 140, 160 and thereby create a suction or vacuum force to clamp the substrate to the vacuum clamp 120. When a substrate is to be released from a substrate support 42 the vacuum system 100 may provide gas (e.g. clean air) to the apertures 130, 150 via the channels 140, 160 to break a vacuum seal between the substrate and the vacuum clamp 120 thereby releasing the substrate from the vacuum clamp 120. Each vacuum clamp 120 can be actuated individually, thereby allowing each substrate to be clamped or released without effecting the other stored substrates.

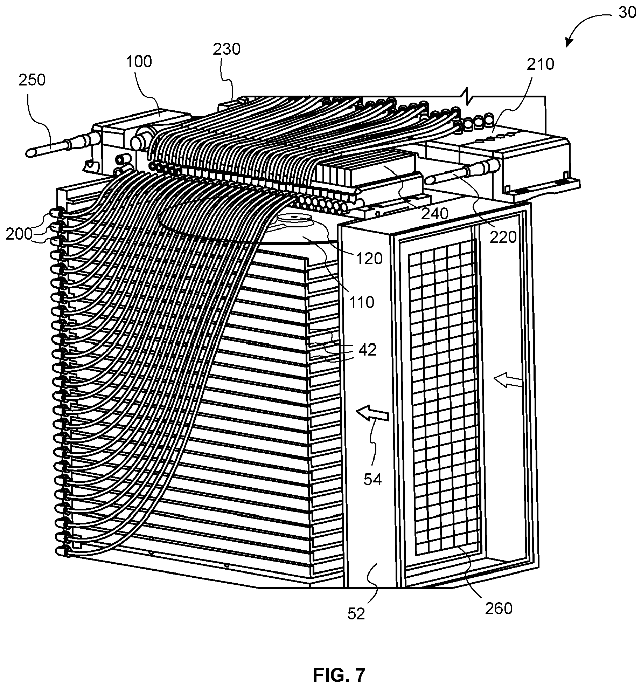

Fig. 7 schematically depicts an alternative arrangement of the vacuum system 100 in accordance with the present disclosure. In the example of Fig. 7, the vacuum system 100 is arranged on top of the column of substrate supports 42 (compared to the side arrangement of Fig. 5). The vacuum system 100 comprises a plurality of channels 200 fluidly coupled to the plurality of substrate supports 42. Each channel 200 is configured to control the vacuum clamp 120 of each substrate support 42. The vacuum system 100 may comprise at least one channel 200 per vacuum clamp 120. The vacuum system 100 comprises a valve manifold 210 configured to control the flow of gas along each channel 200 and thereby control clamping and releasing of each vacuum clamp 120 individually. The valve manifold 210 may comprise at least one valve per channel 200. For example, if the substrate storage module 30 comprises twenty-four substrate supports 42 then the valve manifold 210 may comprise twenty-four valves. Each valve is individually controllable such that substrates 110 may be individually vacuum clamped to and released from the substrate supports. 42. The valve manifold 210 may comprise bi-stable valves. Bi-stable valves advantageously provide continued clamping of any clamped substrates 110 in the event of the vacuum system 100 failing. The bi-stable valves may be actuated electronically. The valve manifold 210 may be fluidly coupled to a vacuum apparatus (not shown) via a valve manifold conduit 220.

The vacuum system 100 comprises a sensing system 230 configured to detect the presence of substrates 110 in the plurality of substrate supports 42. That is, the sensing system 230 is configured to determine whether or not the substrate supports 42 in the substrate storage module 30 are occupied by a substrate 110. The sensing system 230 may comprise one or more pressure sensors in fluid communication with the channels 200. In the example of Fig. 7, the sensing system 230 comprises a pressure sensor manifold 240 comprising a plurality of pressure sensors. The pressure sensor manifold 240 may comprise at least one pressure sensor per substrate support 42. For example, if the substrate storage module 30 comprises twenty-four substrate supports 42 then the sensing system manifold 240 may comprise twenty-four pressure sensors. At least one pressure sensor may be in fluid communication with each channel 200. The presence or absence of a substrate on each substrate support 42 can be determined individually by the corresponding pressure sensor determining the presence or absence of a vacuum at each vacuum clamp 120. If a pressure sensor detects the presence of a vacuum, it can be determined that a substrate 110 is clamped by the vacuum clamp 120 and is therefore present on the substrate support 42. If the pressure sensor does not detect the presence of a vacuum, it can be determined that no substrate is present on the substrate support 42. The pressure sensor manifold 240 may be fluidly coupled to a vacuum apparatus (not shown) via a pressure sensor manifold conduit 250. Each pressure sensor in the pressure sensor manifold 240 may, for example, provide a signal that is indicative of whether or not a substrate support 42 is occupied by a substrate 110 to a processor (not shown). The processor may be configured to receive the signal from the sensing system 230 and control movement of the actuator 64 and/or the robotic arm 35 in dependence on the signal received from the sensing system 230 such that the robotic arm 35 only places incoming substrates 110 in unoccupied substrate supports 42.

The substrate storage module 30 may comprise a grounded conductor 260 configured to reduce a risk of electrostatic discharge between stored substrates 110. For example, the grounded conductor 260 may comprise a metallic mesh or conductive filter cloth. The grounded conductor 260 may be configured to discharge the flow of gas 54 that is provided by the gas delivery system 52 and blown over exposure surfaces of the stored substrates 110. The grounded conductor 260 may be located downstream of a gas filter such that gas particles that become charged via an interaction with the filter are discharged by the grounded conductor 260 before being provided across an exposure surface of the stored substrates 110.

Referring again to Fig. 5, each substrate support 42 comprises a coating configured to reduce friction between the substrate support 42 and a substrate 110 supported by the substrate support 42. In the example of Fig. 5, the coating is provided on portions of the vacuum clamp 120 that are configured to come into contact with the stored substrates 110 (e.g. the raised inner and outer rings of the vacuum clamp 120 shown in Fig. 6). The coating may, for example, comprise diamond-like carbon. The coating acts to reduce frictional forces between the substrates 110 and the substrate supports 42, thereby reducing the risk of defects (e.g. substrates backside defects) and/or the risk of the generation of contaminants via frictional interactions.

The substrate supports 42 are configured to be individually removable from the substrate storage module 30. The substrate storage module 30 may comprise an attachment mechanism configured to couple and decouple substrate supports 42 to the substrate storage module 30. For example, the substrate supports 42 may be inserted into slots formed in a support column 44 or support arm 170 and the attachment mechanism may be actuated to secure the substrate support 42 in place. The attachment mechanism may comprise any suitable reversible connection means such as, for example, a pin and socket arrangement, a detent connector, a clip, a latch, a bayonet connector, magnetic retention means, etc. Having individually removable substrate supports 42 allows each substrate support 42 to be taken away for maintenance (e.g. cleaning) or disposal without disrupting the other substrate supports 42. For example, a substrate support 42 may be defective, in which case a user may remove the defective substrate support from the substrate storage module 30 and replace the defective substrate support with a spare functional substrate support 42. As another example, a substrate support 42 may require maintenance (e.g. cleaning), in which case the user may remove the substrate support from the substrate storage module 30 for cleaning and/or fixing before reinserting the substrate support. The plurality of substrate supports 42 may be configured to be individually replaceable, e.g. in a manner similar to cassettes.

A method of storing a plurality (e.g. at least eighteen) substrates in a controllable environment for protecting the substrates from ambient air comprises using a vacuum system (e.g. the vacuum system 100 of Figs. 5-7) to individually clamp and release the substrates from a plurality of substrate supports (e.g. the substrate supports 42 of Figs. 5-7). The method may comprise using the vacuum system 100 to detect the presence of the substrates in the plurality of substrate supports 42. For example, the pressure sensor manifold 240 of Fig. 7 may be used to determine the presence or absence of substrates on the substrate supports 42. The method may comprise providing a flow of gas 54 across each substrate 110. For example, the gas delivery system 52 of Figs. 4-7 may be used to provide uniform flows of gas 54 across the exposure surface of each substrate 110. The gas may comprises filtered air. The gas may comprise low humidity. The gas may comprise extreme clean dry air. The method may comprise providing a grounded conductor to reduce a risk of electrostatic discharge between the substrates 110. For example, the metallic mesh 260 of Fig. 7 may be used to discharge the flow of gas 54 provided by the gas delivery system 52 before the flow of gas 54 is provided across the exposure surfaces of the substrates 110.

The method may comprise storing the substrates in a non-linear sequence. Known substrate storage methods involve storing the substrates in a linear sequence. For example, known substrate storage methods involve storing substrates in a first substrate support, followed by a second substrate support adjacent the first substrate support, followed by a third substrate support adjacent the second substrate support, etc. For example, a known method of storing six substrates involves storing the substrate in the following linear sequence of substrate supports: 1, 2, 3, 4, 5, 6 In this example, the distance between the first substrate (i.e. stored in substrate support 1) and the final substrate (i.e. in substrate support 6) is relatively large. By storing the substrates in a non-linear sequence (e.g. storing six substrates in the following non-linear sequence of substrate supports: 1, 3, 5, 6, 4, 2), then the distance between the first substrate (i.e. stored in substrate support 1) and the final substrate (i.e. stored in substrate support 2) is reduced compared to the known method. This advantageously reduces the variety of distances needed to store or remove each substrate compared to the extremes of the known method. This may in turn reduce unwanted movement of the substrates.

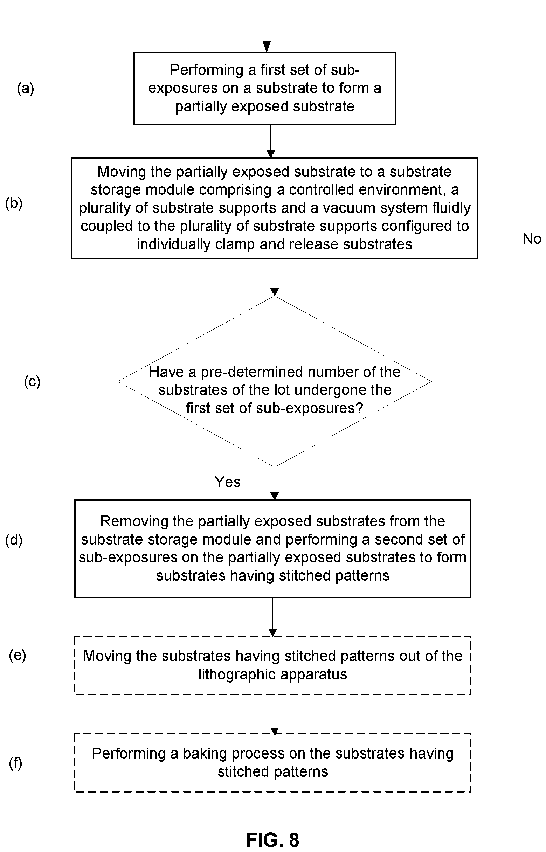

Fig. 8 is a flow chart showing a method of exposing a plurality of substrates to form a stitched pattern on the substrates according to an aspect of the present disclosure. A first step (a) of the method comprises performing a first set of sub-exposures on a substrate to form a partially exposed substrate. For example, with reference to Fig. 3, a substrate W may be retrieved from the track interface 37 (e.g. via a store unit) by a robotic arm 35a and placed on a substrate measurement stage 33. Characteristics such as, for example, a position and/or a temperature of the substrate W may be measured by the substrate measurement stage 33. A robotic arm 35b may then retrieve the substrate W from the substrate measurement stage 33 and place the substrate in the transition module 34. The transition module 34 may generate a vacuum environment before a robotic arm 35c in the vacuum module 36 retrieves the substrate W from the transition module 34. In the case of a dual stage lithographic apparatus, the robotic arm 35c may then place the substrate W on a substrate table on a measurement stage (not shown) within the vacuum module 36. The measurement stage may be configured to measure characteristics of the substrate W such as, for example, positions of alignment features of the substrate and/or a topography of the substrate. A robotic arm 35d may then swap the substrate table from the measurement stage with a substrate table from an exposure stage, such as the substrate table WT depicted in Fig. 1. The first set of sub-exposures may then take place whilst the substrate W is held by the substrate table.

Referring again to Fig. 8, a second step (b) of the method comprises moving the partially exposed substrate to a substrate storage module comprising a controlled environment, a plurality of substrate supports and a vacuum system fluidly coupled to the plurality of substrate supports configured to individually clamp and release substrates. For example, with reference to Fig. 3, a robotic arm 35d may retrieve the partially exposed substrate W from the substrate table (not shown) and place the partially exposed substrate in the transition module 34. The transition module 34 may then replace the vacuum environment with an ambient environment. A robotic arm 35a may then retrieve the partially exposed substrate from the transition module 34 and place the partially exposed substrate on a substrate support of the substrate storage module 30. The substrate storage module 30 may be configured to store at least eighteen substrates. The substrate storage module 30 may be an integral part of the lithographic apparatus. Alternatively, the substrate storage module 30 may be an integral part of the vacuum module 36 (see Fig. 3).

Referring again to Fig. 8, a third step (c) of the method comprises repeating the first step (a) and the second step (b) for a pre-determined number of substrates. That is, subsequent substrates undergo the first set of sub-exposures to become partially exposed substrates before being moved into the substrate storage module for protection from ambient air and vacuum clamping. The pre-determined number of substrates may correspond to one less than the total number of substrates in the lot. This is because when the final substrate is undergoing the first sub-exposure, the first substrate may already be unloaded from the substrate storage module. That is, not all substrates may have undergone the first sub-exposure before a partially exposed substrate is removed from the substrate storage module for undergoing the second sub-exposure. Steps (a) and (b) may be repeated for substrates of the lot which have not yet undergone the first set of sub-exposures. A fourth step (d) of the method comprises removing the partially exposed substrates from the substrate storage module and performing a second set of sub-exposures on the partially exposed substrates to form substrates having stitched patterns. The second set of sub-exposures takes place using a different patterning device, or a different part of the same patterning device. That is, the pattern imparted to the substrate in the second set of sub-exposures is different to the pattern imparted to the substrate in the first set of sub-exposures. For example, with reference to Fig. 3, a partially exposed substrate may be retrieved from the substrate storage module 30 by a robotic arm 35b and placed in the transition module 34. The transition module 34 may generate a vacuum environment before a robotic arm 35c in the vacuum module 36 retrieves the partially exposed substrate from the transition module 34. In the case of a dual stage lithographic apparatus, the robotic arm 35c may then place the partially exposed substrate on a substrate table on a measurement stage (not shown) within the vacuum module 36. The measurement stage may be configured to measure characteristics of the partially exposed substrate. A robotic arm 35d may then swap the substrate table from the measurement stage with a substrate table from an exposure stage, such as the substrate table WT depicted in Fig. 1. The second set of sub-exposures may then take place to form a substrate having a stitched pattern. It will be appreciated that a stitched lithographic exposure process may involve performing more than two sets of sub-exposures on the plurality of substrates. As such, the method may comprise storing and removing partially exposed substrates in the wafer storage module on more than one occasion throughout the stitched lithographic exposure process.

Referring again to Fig. 8, an optional fifth step of the method comprises moving the substrates having stitched patterns out of the lithographic apparatus. An optional sixth step (f) of the method comprises performing a baking process on the substrates having stitched patterns. For example, with reference to Fig. 3, a substrate having a stitched pattern may be moved by robotic arms 35a-d from the vacuum module 36, through the transition module 34 and placed on the track interface 37 (e.g. via a store unit) in the atmospheric module 32. A robotic arm (not shown) in a resist processing apparatus may retrieve the substrate having a stitched pattern from the track 38 and place the substrate in the resist processing apparatus such that a baking process may be performed on the substrate. Alternatively, if the resist processing apparatus is unavailable, the substrates having a stitched pattern may be returned to the substrate storage module 30 for protection from ambient air until they are able to undergo resist processing. In contrast, the substrate carrier 31 would hold the substrates in ambient air.

Whilst the use of a lithographic apparatus LA comprising a substrate storage module 30 has been described in the context of storing substrates 40 that are to undergo a stitched lithographic exposure, the lithographic apparatus LA comprising the substrate storage module 30 may be used for other types of lithographic exposure. For example, the substrate storage module 30 may be used to store singly exposed substrates until a resist processing apparatus is ready to receive the singly exposed substrates.

The substrate storage module 30 may form part of a metrology apparatus. The metrology apparatus may be used to measure alignment of a projected pattern formed in resist on a substrate relative to a pattern already present on the substrate. This measurement of relative alignment may be referred to as overlay. The metrology apparatus may for example be located immediately adjacent to a lithographic apparatus LA and may be used to measure the overlay before the substrate (and the resist) has been processed. The substrate storage module 30 may, for example, be used to store lithographically exposed substrates in a controlled environment before the substrates are provided to the metrology apparatus for measurement. As another example, substrates configured for calibrating the metrology apparatus may be stored in the substrate storage module for quick access when needed.

Although specific reference may be made in this text to aspects of the present disclosure in the context of a lithographic apparatus, aspects of the present disclosure may be used in other apparatus. Aspects of the present disclosure may form part of a metrology apparatus, or any apparatus that measures or processes an object such as a wafer (or other substrate). These apparatus may be generally referred to as lithographic tools. Such a lithographic tool may use vacuum conditions or ambient (nonvacuum) conditions whilst the substrate storage module comprises a controlled environment which protects substrates from ambient air.

The term "EUV radiation" may be considered to encompass electromagnetic radiation having a wavelength within the range of 4-20 nm, for example within the range of 13-14 nm. EUV radiation may have a wavelength of less than 10 nm, for example within the range of 4-10 nm such as 6.7 nm or 6.8 nm.

Although Fig. 1 depicts the radiation source SO as a laser produced plasma LPP source, any suitable source may be used to generate EUV radiation. For example, EUV emitting plasma may be produced by using an electrical discharge to convert fuel (e.g. tin) to a plasma state. A radiation source of this type may be referred to as a discharge produced plasma (DPP) source. The electrical discharge may be generated by a power supply which may form part of the radiation source or may be a separate entity that is connected via an electrical connection to the radiation source SO.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.

Although specific reference may have been made above to the use of the substrate storage module in the context of optical lithography, it will be appreciated that the substrate storage module may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

Aspects of the present disclosure may be implemented in hardware, firmware, software, or any combination thereof. Aspects of the present disclosure may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

While specific aspects of the present disclosure have been described above, it will be appreciated that the substrate storage module and method of storing substrates may be practiced otherwise than as described. The descriptions above are intended to be illustrative, not limiting. Thus it will be apparent to one skilled in the art that modifications may be made to the aspects of the present disclosure as described without departing from the scope of the claims set out below.

## Claims

1. A substrate storage module for use as an integral part of a lithographic apparatus comprising:
a controllable environment for protecting a plurality of substrates from ambient air;
a plurality of substrate supports for receiving the substrates; and,
a vacuum system fluidly coupled to the plurality of substrate supports configured to individually clamp and release the substrates.

2. The substrate storage module of claim 1, wherein the plurality of substrate supports comprises a coating configured to reduce friction between the plurality of substrate supports and the substrates.

3. The substrate storage module of claim 2, wherein the coating comprises diamond-like carbon.

4. The substrate storage module of any preceding claim, wherein the plurality of substrate supports are configured to be individually removable from the substrate storage module.

5. The substrate storage module of any preceding claim, wherein the vacuum system comprises a sensing system configured to detect the presence of the substrates in the plurality of substrate supports.

6. The substrate storage module of any preceding claim, comprising a gas delivery system configured to provide a flow of gas across each substrate support within the substrate storage module.

7. The substrate storage module of claim 6, wherein the gas comprises filtered air.

8. The substrate storage module of claim 6 or claim 7, wherein the gas comprises low humidity.

9. The substrate storage module of claim 7 and claim 8, wherein the gas comprises extreme clean dry air.

10. The substrate storage module of any preceding claim, wherein the number of substrate supports is less than twenty-five.

11. The substrate storage module of any preceding claim, comprising a grounded conductor configured to reduce a risk of electrostatic discharge between the substrates.

12. A lithographic apparatus arranged to project a pattern from a patterning device onto a substrate, comprising the substrate storage module of any preceding claim.

13. The lithographic apparatus of claim 12, comprising a vacuum substrate handling module, an atmospheric substrate handling module, and a transition substrate handling module disposed between the vacuum substrate handling module and the atmospheric substrate handling module, wherein the substrate storage module is located in the atmospheric substrate handling module.

14. A method of storing a plurality of substrates in a controllable environment for protecting the substrates from ambient air, comprising using a vacuum system to individually clamp and release the substrates from a plurality of substrate supports.

15. A method of lithographically exposing a plurality of substrates to form a stitched pattern on the substrates, the method comprising the following steps:
(a) performing a first set of sub-exposures on a substrate to form a partially exposed substrate;
(b) storing the partially exposed substrate in accordance with the method of claim 14;
(c) repeating steps (a) and (b) for other substrates in the plurality of substrates; and,
(d) removing the partially exposed substrates from storage and performing a second set of sub-exposures on the partially exposed substrates to form substrates having stitched patterns.
